(19) Europäisches Patentamt
European Patent Office
Office européen des brevets

(11) **EP 4 542 857 A1**

(12) **EUROPEAN PATENT APPLICATION**
published in accordance with Art. 153(4) EPC

(43) Date of publication:
**23.04.2025 Bulletin 2025/17**

(21) Application number: **23940018.7**

(22) Date of filing: **26.12.2023**

(51) International Patent Classification (IPC):
*H03H 7/38* *(2006.01)*

(86) International application number:
**PCT/CN2023/142045**

(87) International publication number:
**WO 2025/050567 (13.03.2025 Gazette 2025/11)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **06.09.2023 CN 202311148800**

(71) Applicant: **Calterah Semiconductor Technology
(Shanghai)
Co., Ltd.
Shanghai 201210 (CN)**

(72) Inventors:
• **WANG, Jiawen**
  **Shanghai 201210 (CN)**
• **LIU, Zhengdong**
  **Shanghai 201210 (CN)**
• **ZHOU, Wenting**
  **Shanghai 201210 (CN)**

(74) Representative: **Arnold & Siedsma
Bezuidenhoutseweg 57
2594 AC The Hague (NL)**

(54) **MATCHING NETWORK, FREQUENCY MIXER, PHASE SHIFTER, RADAR SENSOR, AND ELECTRONIC DEVICE**

(57) A matching network of a radio frequency signal, a mixer, a phase shifter, a radar sensor and an electronic apparatus. The matching network of the radio frequency signal includes a first inductor (L1) having an I input terminal, a second inductor (L2) having a Q input terminal, and a third inductor (L3) inductively coupled to both the first inductor and the second inductor, the third inductor has an output terminal; wherein the I input terminal is configured to receive a radio frequency signal of an I channel, and the Q input terminal is configured to receive a radio frequency signal of a Q channel.

FIG. 3

## Description

This application claims priority of Chinese Patent Application No. 202311148800.3 filed on September 6, 2023, to the China National Intellectual Property Administration, entitled "Matching network, Mixer, Phase Shifter, Radar Sensor and Electronic Apparatus", the contents of which should be regarded as being incorporated herein by reference.

Technical Field

The present disclosure relates to, but is not limited to, the field of semiconductor technology, particularly relates to a matching network of a radio frequency signal, a mixer, a phase shifter, a radar sensor, and an electronic apparatus.

Background

Integrated circuit (IC), also known as chip, is a way to miniaturize circuits in electronics, and it is often manufactured on a surface of a semiconductor wafer. The chip includes a die manufactured using a semiconductor manufacturing process, and an encapsulation structure.
A mixer for frequency conversion is typically included in a radio frequency chip structure. Herein, some mixers, such as single sideband mixers, are widely used because of its good suppression of image signals. However, an output circuit of a single sideband mixer needs to mix I (in-phase) and Q (quadrature) signals with a phase difference of 90° for subsequent circuit processing. However, when two channels of signals are mixed, there is a problem that an isolation of the two channels of signals is poor. The problem may also exist in other circuits that need to realize IQ signal mixing, such as an IQ phase shifter.

Summary

The following is a summary of the subject matter described in detail herein. This summary is not intended to limit the scope of protection of the claims.
Embodiments of the present disclosure provide a matching network of a radio frequency signal, a mixer, a phase shifter, a radar sensor, and an electronic apparatus, which can avoid leakage between two channels (I and Q channels) and improve isolation.
In one aspect, an embodiment of the present disclosure provides a matching network of a radio frequency signal, including a first inductor having an I input terminal, a second inductor having a Q input terminal, and a third inductor inductively coupled with both the first inductor and the second inductor, the third inductor having an output terminal; wherein the I input terminal is configured to receive a radio frequency signal of an I channel, and the Q input terminal is configured to receive a radio frequency signal of a Q channel.
In another aspect, an embodiment of the present disclosure also provides a mixer including the aforementioned matching network.
In another aspect, an embodiment of the present disclosure further provides a phase shifter including the aforementioned matching network.
In yet another aspect, an embodiment of the present disclosure further provides a radar sensor including the aforementioned mixer or phase shifter.
In yet another aspect, an embodiment of the present disclosure further provides an electronic apparatus including the aforementioned radar sensor.
After the drawings and detailed description are read and understood, other aspects can be understood.

Brief Description of Drawings

The accompanying drawings are used for providing understanding of technical solutions of the present disclosure, and form a part of the specification. They are used for explaining the technical solutions of the present disclosure together with the embodiments of the present disclosure, but do not form a limitation on the technical solutions of the present disclosure.

    FIG. 1 is a schematic diagram of signal leakage of a single sideband mixer.
    FIG. 2 is a schematic diagram of a connection relationship between I and Q mixers and an IQ combining and matching network.
    FIG. 3 is a schematic circuit diagram of a matching network of a radio frequency signal provided by an embodiment of the present disclosure.
    FIG. 4A is a schematic diagram of a shape and positional relationship between a first inductor and a second inductor according to an embodiment of the present disclosure.

FIG. 4B is a schematic diagram of a shape of a third inductor according to an embodiment of the present disclosure.

FIG. 4C is a schematic diagram of a matching network according to an embodiment of the present disclosure.

FIG. 5A is a schematic diagram of another shape and positional relationship of a first inductor and a second inductor according to an embodiment of the present disclosure.

FIG. 5B is a schematic diagram of another shape of a third inductor according to an embodiment of the present disclosure.

FIG. 5C is a schematic diagram of another matching network according to an embodiment of the present disclosure.

FIG. 6 is a schematic diagram of a position of a third inductor according to an embodiment of the present disclosure.

FIG. 7 is another schematic diagram of another position of the third inductor according to an embodiment of the present disclosure.

FIG. 8 is a schematic diagram of signal combination of a passive matching network according to an embodiment of the present disclosure.

FIG. 9 is a schematic diagram of a connection mode of a tap according to an embodiment of the present disclosure.

FIG. 10 is a schematic diagram of another connection mode of a tap according to an embodiment of the present disclosure.

FIG. 11 is a schematic diagram of still another connection mode of a tap according to an embodiment of the present disclosure.

FIG. 12A is a schematic diagram of a connection between a first tap and a first inductor.

FIG. 12B is a schematic diagram of a connection between a second tap and a second inductor.

FIG. 13 is a schematic diagram of a circuit of a radar chip.

FIG. 14 is a schematic diagram of a passive matching network applied to an IQ phase shifter according to an embodiment of the present disclosure.

Detailed Description

Multiple embodiments are described in the present disclosure, but the description is exemplary rather than restrictive, and it is apparent to those of ordinary skills in the art, there may be more embodiments and implementation solutions within the scope contained in the embodiments described herein. Although many possible feature combinations are shown in the drawings and discussed in the detailed description, many other combinations of disclosed features are possible. Unless expressly limited, any feature or element of any embodiment may be used in combination with, or may replace, any other feature or element in any other embodiment.

The present disclosure includes and contemplates combinations with features and elements known to those of ordinary skills in the art. The disclosed embodiments, features and elements of the present disclosure may also be combined with any conventional features or elements to form the unique technical solutions defined by the claims. Any feature or element of any embodiment may also be combined with features or elements from other technical solutions to form another unique technical solution defined by the claims. Accordingly, it should be understood that any of the features shown and/or discussed in the present disclosure may be implemented alone or in any suitable combination. Thus the embodiments are not subject to limitations other than those made in accordance with the appended claims and their equivalent substitutions. In addition, various modifications and changes can be made within the protection scope of the appended claims.

In the present specification, "parallel" means that two straight lines on a plane, or two straight lines in a space, or two planes in a space, or a straight line in a space and a plane do not have any common point, and "perpendicular" means that one line in a plane intersects another line and forms a right angle, or one line in a space intersects another straight line and forms a right angle, or two planes in a space intersect and form a right angle, or a straight line in a space intersects one plane and forms a right angle. However, considering the implementation of the actual process, there may be some errors, so the term "parallel" herein includes approximately parallel, and the term "perpendicular" herein includes approximately perpendicular.

In the present specification, "a plurality" and "two or more" have same meaning, and "two or more" includes "two".

In a radio frequency band such as a millimeter wave frequency band, due to a compact layout area, it is difficult for a circuit that generates I and Q signals to avoid the characteristics of a short physical distance in a region where signals are combined and output. This makes the two signals easily leak between the two channels (I channel and Q channel) and between the IQ circuit and the output circuit through magnetic coupling, substrate coupling and electrical coupling, thereby reducing an isolation between the I and Q signal lines. In a circuit such as I and Q mixers, it can reduce an image rejection ratio and alleviate deterioration of local oscillator and the like.

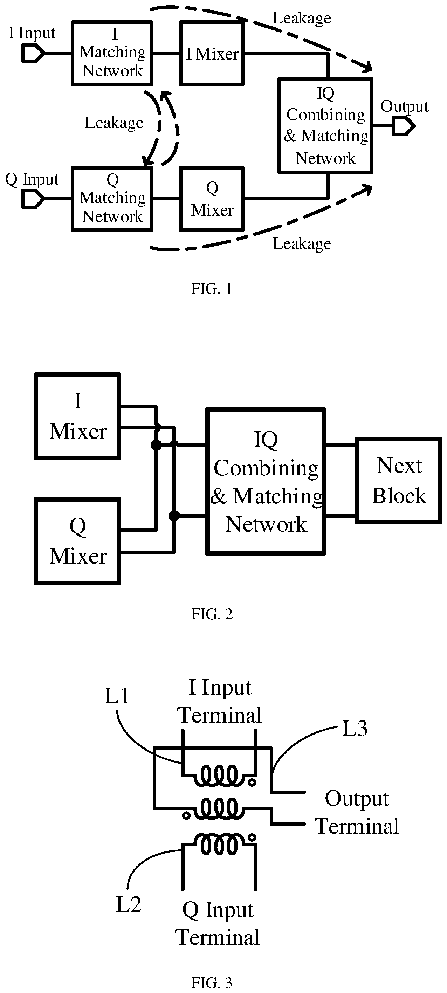

FIG. 1 is a schematic diagram of signal leakage of a single sideband mixer. As shown in FIG. 1, an I input signal reaches an IQ combining and matching network through an I matching network and an I Mixer, and a Q input signal reaches the IQ combining and matching network through a Q matching network and a Q Mixer. The I signal and the Q signal are output by the IQ combining and matching network. A matching network is a circuit configured to adjust an impedance matching between an input and output of the circuit. By selecting appropriate component parameter and topology, the matching network can achieve a maximum power transmission and optimization of signal quality. It can be seen from the figure that there are leakages between the two matching networks (I and Q matching networks) and between the I and Q matching networks and outputs of the mixers.

In order to ensure combing and impedance matching of the two signals, i.e., I and Q signals, a connection relationship between the I and Q mixers and the IQ combing and matching network is shown in FIG. 2. The outputs of the two channels (I and Q channels) of the mixers are connected in a short-circuited manner together, and then matched to a next circuit through an IQ combining and matching network. The IQ combining and matching network may be, for example, a multi-stage circuit including a matching circuit and a transformer. However, such circuit may have a problem of leakage caused by the short-circuited connection of the two channels (I and Q channels) or the multi-stage circuit, and a problem of an incomplete symmetry between a connected part of the I mixer and the IQ combining and matching network and a connected part of the Q mixer and the IQ combining and matching network, which leads to a problem of asymmetry of the differential mode paths and common mode paths of I and Q channels.

Therefore, embodiments of the present disclosure provide a matching network of a radio frequency signal, configured to perform IQ combination and impedance matching. The matching network includes a first inductor L1 having an I input terminal, a second inductor L2 having a Q input terminal, and a third inductor L3 inductively coupled with both the first inductor and the second inductor. The third inductor has an output terminal (i.e. the output terminal of the matching network for connecting a next stage circuit). The I input terminal is configured to receive a radio frequency signal of an I channel, and the Q input terminal is configured to receive a radio frequency signal of a Q channel. FIG. 3 is a schematic diagram of a circuit of a matching network of a radio frequency signal provided by an embodiment of the present disclosure, and connections of the inductors in the circuit in the figure are only schematic.

In an embodiment of the present disclosure, the first inductor is provided for the I input, the second inductor is provided for the Q input, and the third inductor is provided for the output, respectively, and they are inductively coupled by the three inductors. The coupling of multiple inductors not only increases a trace spacing between the two signals (I and Q signals), that is, increases an isolation of the I and Q signals, but also realizes the combination of the two signals (I and Q signals).

The above-mentioned inductive coupling refers to a coupling between circuits or devices through magnetic field interaction. It transmits a signal from one coil to another coil using a principle of electromagnetic induction, thereby realizing contactless transmission of signals.

In an exemplary embodiment, the first inductor and the second inductor are arranged symmetrically. For example, the first inductor and the second inductor are symmetrical with respect to a symmetry axis. As a result, the I input terminal and the Q input terminal are also symmetrical with respect to the symmetry axis. By symmetrical arrangement, introduction of additional phase difference due to inconsistent lengths of traces from the I input terminal and the Q input terminal to the transformer coil is avoided. By completely symmetrical arrangement, robustness of a passive network and a resistance to process instability can be improved, and moreover, a problem of asymmetry of differential mode paths and common mode paths of the I and Q channels can be avoided.

For example, the I input terminal and the Q input terminal are arranged along a second direction (longitudinal Y-axis direction), and a center line between them extends along a first direction (transverse X-axis direction), and the center line is also a symmetry axis of the I input terminal and the Q input terminal. The first direction is perpendicular to the second direction. The first inductor and the second inductor may be arranged between the I input terminal and the Q input terminal, and may be symmetrical with respect to a first symmetry axis, and the first symmetry axis extends along the first direction. That is, the I input terminal and the Q input terminal are symmetrically arranged at positions away from the first symmetry axis, and coil bodies of the first inductor and the second inductor are symmetrical with respect to the first symmetry axis. By arranging the passive network between the two input terminals (I and Q input terminals), a physical distance between the two input terminals is increased, mutual coupling between the two signals (I and Q signals) can be reduced, a image rejection ratio can be improved, suppression of a signal leakage between the two signals (I and Q signals) can be enhanced, and a layout can be facilitated. By symmetrically arranging the I input terminal and the Q input terminal at positions away from the first symmetry axis, in addition to suppressing the signal leakage between the two channels (I and Q channels), a phase error can be avoided, robustness of the passive network and a resistance to process instability can be improved.

In an exemplary embodiment, the first inductor and the second inductor may both have a symmetrical structure. A symmetry axis of the first inductor and a symmetry axis of the second inductor may be the same symmetry axis or different symmetry axes. For example, the first inductor and the second inductor are both symmetrical with respect to a second symmetry axis, and the second symmetry axis extends along the second direction. For example, the second symmetry axis is perpendicular to the first symmetry axis. By arranging both the first inductor and the second inductor to be symmetrical structures, the passive network is more symmetrical, and the robustness of the passive network is further improved. Exemplarily, shapes of the first inductor and the second inductor may be identical.

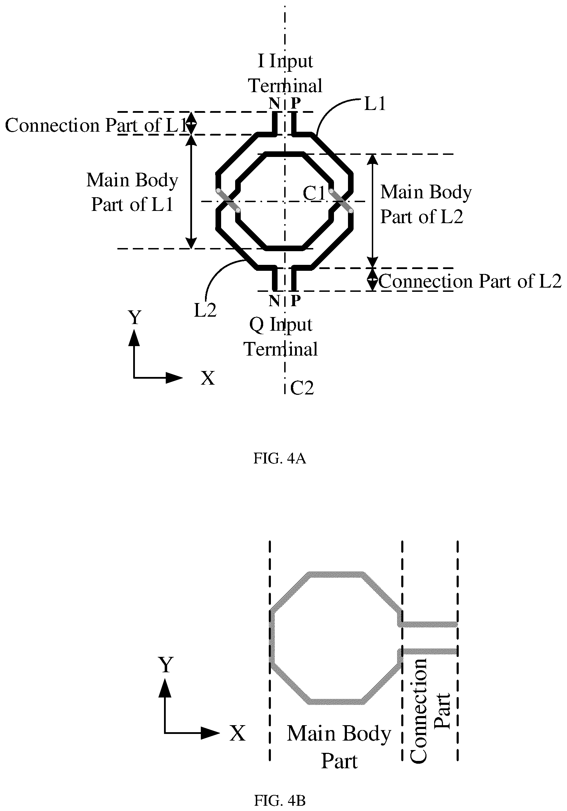

FIG. 4A is an example of one positional relationship between the first inductor and the second inductor. In FIG. 4A, both of the first inductor and the second inductor are substantially located on a first metal layer. In order to prevent short-circuited connection at an intersection of the first inductor and the second inductor, a coil bridging may be achieved through a metal via and a second metal layer. In the figure, the first inductor L1 and the second inductor L2 are arranged along the second direction Y, and the symmetry axis of the first inductor L1 and the second inductor L2 is the first symmetry axis C1, and in this example, both L1 and L2 are symmetrical with respect to the second symmetry axis C2.

In an exemplary embodiment, it may be provided that an orthographic projection of the first inductor and an orthographic projection of the second inductor are partially overlapped, that is, the first inductor and the second inductor are overlapped, and an intersecting position thereof may be insulated by traces on another metal layer, so that the first inductor and the second inductor can be coupled with the third inductor better.

In order to better couple the third inductor with the first inductor and the second inductor, the third inductor may also be a symmetrical structure. In some embodiments, the third inductor may not be a symmetrical structure. Alternatively, a symmetry axis of the third inductor may be parallel to or coincides with the first symmetry axis of the first inductor and the second inductor.

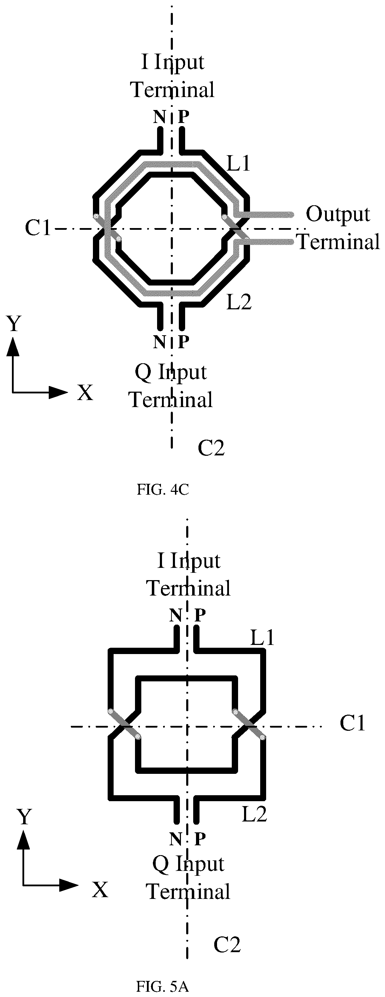

In an exemplary embodiment, the I input terminal and the Q input terminal are arranged orthogonally to the output terminal, respectively, as shown in FIG. 4C, the first inductor and the second inductor are arranged along the second direction Y, that is, the I input terminal and the Q input terminal are arranged along the second direction Y, the symmetry axis of the third inductor extends along the first direction X, and the output terminal is located on the symmetry axis of the third inductor. Since the first direction X is perpendicular to the second direction Y, the output terminal is arranged orthogonally to the I input terminal, and the output terminal is arranged orthogonally to the Q input terminal.

In an exemplary embodiment, an envelope shape of an orthographic projection of the first inductor and the second inductor as a whole may be, for example, a regular octagon, and as shown in FIG. 4A. The whole of the first inductor and the second inductor include a main body part of L1 and a main body part of L2, and as shown in the figure, main body parts of the first inductor and the second inductor as a whole are approximately the regular octagon. Taking the first inductor as an example, a main body part of the first inductor is a coil main body, and a connection part thereof is a part where the coil main body is connected to the I input terminal. Similarly, a main body part of the second inductor is a coil main body, and a connection part thereof is a part where the coil main body is connected to the Q input terminal. The envelope shape of the orthographic projection of the first inductor and the second inductor as a whole is approximately the regular octagon. Alternatively, the envelope shape of the orthographic projection of the first inductor and the second inductor as a whole may also be a rectangular (including a square), as shown in FIG. 5A. Alternatively, the envelope shape of the first inductor and the second inductor as a whole may be another regular polygon or a circular shape, to ensure that the first inductor and the second inductor are symmetrical with respect to the first symmetry axis C1.

In an exemplary embodiment, a metal wire constituting the first inductor and the second inductor may be a straight line or may be a curve, as long as the first inductor and the second inductor are ensured to be symmetrical with respect to the first symmetry axis.

The electromagnetic couplings of the third inductor with the first inductor and the second inductor, respectively, causes one group of image signals flowing through the third inductor to be suppressed and another group of image signals to be enhanced, thus effectively improving the image rejection ratio.

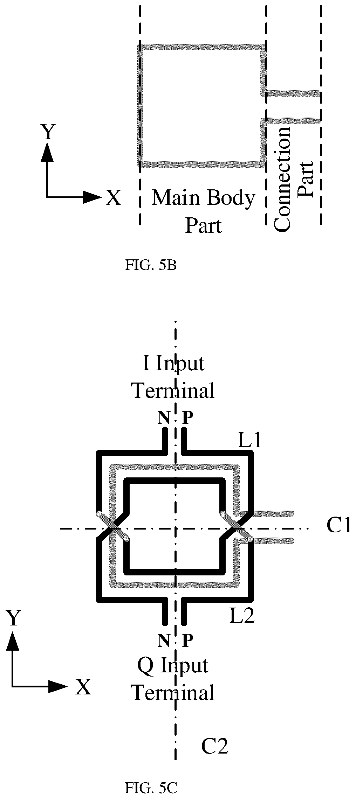

In an exemplary embodiment, for better coupling with the first inductor and the second inductor, a shape of an orthographic projection of the third inductor may be adapted to the envelope shape of the orthographic projection of the first inductor and the second inductor, for example, the envelope shape of the orthographic projection of the first inductor and the second inductor is a regular octagon, and a main body part of the third inductor may also be provided as a regular octagon, as shown in FIG. 4B. For example, the envelope shape of the orthographic projection of the first inductor and the second inductor is a square, and the main body part of the third inductor may also be provided as a square, as shown in FIG. 5B. In some other examples, the shape of the orthographic projection of the third inductor may not be adapted to the shape of the orthographic projection of the first inductor and the second inductor.

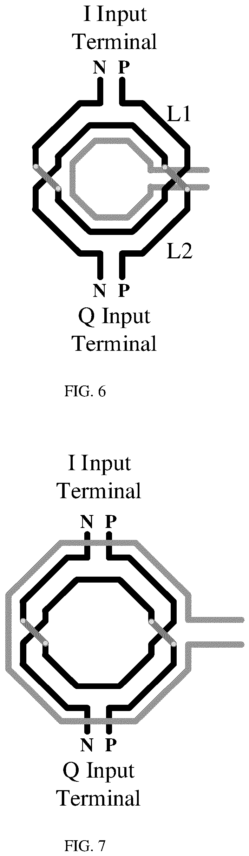

In an exemplary embodiment, the third inductor may be located between the first inductor and the second inductor, for example, the orthographic projection of the third inductor is located between the orthographic projection of the first inductor and the orthographic projection of the second inductor, as shown in FIG. 4C and FIG. 5C, or may be located inside an orthographic projection region (or inside the envelope shape) of the first inductor and the second inductor, as shown in FIG. 6, or may be located outside the orthographic projection region (or outside the envelope shape) of the first inductor and the second inductor, as shown in FIG. 7. The size of the third inductor may be determined by a resonant inductor required by a next stage circuit, and its shape and length are not limited by the shapes of the first inductor and the second inductor.

By arranging the third inductor symmetrically with respect to the third symmetry axis, an orthographic projection of the third symmetry axis coincides with an orthographic projection of the first symmetry axis, and after the third inductor is coupled with the first inductor and the second inductor, a part of the signals input from the I and the Q channels can be counteracted, and another part of the signals input from the I and the Q channels can be enhanced, so that a single sideband signal can be output.

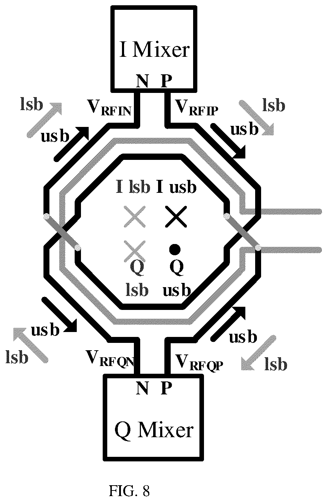

Taking the matching network shown in FIG. 4C being applied to a mixer, and input signals being Local Oscillator signal (LO) and Baseband signal (BB) as an example, FIG. 8 is a schematic diagram of signal combination, showing current directions and magnetic field directions in the matching network.

Voltages of P and N ports of the I and Q mixers after LO signal enters the I and Q mixers are shown in equation (1):

$$V_{LOIP} = A_{LO} \cos(\omega_{LO} t); \ V_{LOIN} = -A_{LO} \cos(\omega_{LO} t)$$

$$V_{LOQP} = A_{LO} \sin(\omega_{LO} t); \ V_{LOQN} = -A_{LO} \sin(\omega_{LO} t) \tag{1}$$

Wherein, $V_{LOIP}$ is a voltage input by the LO signal from P (positive) input port of the I mixer, $V_{LOIN}$ is a voltage input by the LO signal from N (negative) input port of the I mixer, $V_{LOQP}$ is a voltage input by the LO signal from P input port of the Q mixer, $V_{LOQN}$ is a voltage input by the LO signal from N input port of the Q mixer, $A_{LO}$ represents an amplitude value of the LO signal, $\omega_{LO}$ represents an angular velocity of the LO signal, and t represents time.

Voltages of P and N ports of the I and Q mixers after BB signal enters the I and Q mixers are shown in equation (2):

$$V_{BBIP} = A_{BB} \cos(\omega_{BB} t); \ V_{BBIN} = -A_{BB} \cos(\omega_{BB} t)$$

$$V_{BBQP} = A_{BB} \sin(\omega_{BB} t); \ V_{BBQN} = -A_{BB} \sin(\omega_{BB} t) \tag{2}$$

Wherein, $V_{BBIP}$ is a voltage input by the BB signal from the P (positive) input port of the I mixer, $V_{BBIN}$ is a voltage input by the BB signal from the N (negative) input port of the I mixer, $V_{BBQP}$ is a voltage input by the BB signal from the P input port of the Q mixer, $V_{BBQN}$ is a voltage input by the BB signal from the N input port of the Q mixer, $A_{BB}$ represents an amplitude value of the BB signal, $\omega_{BB}$ represents an angular velocity of the BB signal, and t represents time.

According to equations (1) and (2), the output voltage of the mixer is as shown in equation (3),

$$V_{RFIP} = V_{LOIP} * V_{BBIP} + V_{LOIN} * V_{BBIN}$$
$$= A_{LO} A_{BB} [\cos(\omega_{LO} t + \omega_{BB} t) + \cos(\omega_{LO} t - \omega_{BB} t)]$$
$$V_{RFIN} = V_{LOIP} * V_{BBIN} + V_{LOIN} * V_{BBIP}$$
$$= -A_{LO} A_{BB} [\cos(\omega_{LO} t + \omega_{BB} t) + \cos(\omega_{LO} t - \omega_{BB} t)]$$
$$V_{RFQP} = V_{LOQP} * V_{BBQP} + V_{LOQN} * V_{BBQN}$$
$$= A_{LO} A_{BB} [\cos(\omega_{LO} t + \omega_{BB} t) - \cos(\omega_{LO} t - \omega_{BB} t)]$$
$$V_{RFQN} = V_{LOQP} * V_{BBQN} + V_{LOQN} * V_{BBQP}$$
$$= -A_{LO} A_{BB} [\cos(\omega_{LO} t + \omega_{BB} t) - \cos(\omega_{LO} t - \omega_{BB} t)]$$

$$\tag{3}$$

Wherein, $V_{RFIP}$ is a voltage of P output port of the I mixer, $V_{RFIN}$ is a voltage of N output port of the I mixer, $V_{RFQP}$ is a voltage of P output port of the Q mixer, $V_{RFQN}$ is a voltage of N output port of the Q mixer.

Assuming lsb = $A_{LO}A_{BB} \cos(\omega_{LO} t - \omega_{BB} t)$; usb = $A_{LO}A_{BB} \cos(\omega_{LO} t + \omega_{BB} t)$ Equation (3) may be expressed as follows:

$$V_{RFIP} = \text{lsb} + \text{usb}$$

$$V_{RFIN} = -\text{lsb} - \text{usb}$$

$$V_{RFQP} = \text{usb} - \text{lsb}$$

$$V_{RFQN} = -\text{usb} + \text{lsb}$$

As can be seen from the figure, at this time, the magnetic fields of lsb are superimposed and the magnetic fields of usb are counteracted, and the single sideband signal can be output, thus saving spectrum resources and transmission power.

In an exemplary embodiment, the first inductor may further have a first tap for connecting a bias power supply (VDD), and the first tap may be arranged at a position close to the I input terminal, or arranged at a position close to the Q input terminal. Taking the matching network applied to the mixer as an example, the bias power supply is configured to provide an appropriate bias voltage to the mixer to maintain the mixer working normally.

In an exemplary embodiment, the second inductor may further have a second tap for connecting a bias power supply, and the second tap may be arranged at a position close to the Q input terminal, or arranged at a position close to the I input terminal.

In an exemplary embodiment, the first tap of the first inductor is arranged symmetrically with the second tap of the second inductor. For example, the first tap and the second tap are symmetrical with respect to the first symmetry axis. Taking the matching network applied to the mixer as an example, the first tap of the first inductor and the I mixer may form an I-mixer common-mode path, and the second tap of the second inductor and the Q mixer may form a Q-mixer common-mode path. When the first tap and the second tap are symmetrically arranged, the common-mode paths out by the mixers can be made more symmetrically. In addition, by providing taps for the first inductor and the second inductor respectively, voltages of the I mixer and the Q mixer can be adjusted respectively, which is more flexible.

In an exemplary embodiment, a connection point of the first tap and the first inductor is located on a center line between the P terminal and the N terminal of the I input terminal (hereinafter referred to as the P terminal and the N terminal of the I channel), so that a length of the common mode path of the P terminal and a length of the common mode path of the N terminal in the I channel are identical. Similarly, a connection point of the second tap and the second inductor is located on a center line between the P terminal and the N terminal of the Q input terminal (hereinafter referred to as the P terminal and the N terminal of the Q channel), so that a length of the common mode path of the P terminal and a length of the common mode path of the N terminal in the Q channel are identical. Since the lengths of common mode paths at P terminal and N terminal in the two channels are identical, the symmetry of P and N is better, the leakage of local oscillator signal is smaller, and the asymmetry between common mode paths and differential mode paths is solved.

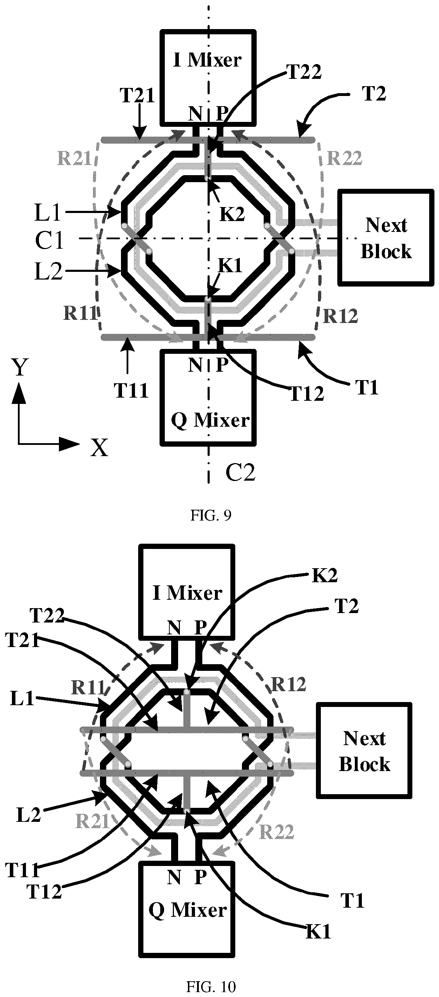

In an exemplary embodiment, taking the matching network to be connected with the I mixer and the Q mixer as an example, a connection mode of one tap may be shown in FIG. 9. It can be seen that the first tap T1 and the second tap T2 are symmetrical with respect to the first symmetry axis C1, and an orthographic projection of a connection point K1 between the first tap T1 and the first inductor L1 is on a center line between the P terminal and the N terminal of the I channel (that is, the second symmetry axis C2). In this example, the first tap T1 is T-shaped, wherein the T-shaped first tap T1 includes a first main line T11 and a first connection line T12, the first connection line T12 is configured to connect the first main line T11 and the first inductor L1, an orthographic projection of the first connection line T12 overlaps with an orthographic projection of the center line of P and N of the I input terminal, the connection point K1 between the first connection line T12 and the first inductor L1 is located on a metal line of the first inductor L1 away from the I input terminal, and the first connection line T12 extends in a direction away from the I input terminal, so as to make the first connection line T12 away from the I input terminal and prolong the I common-mode path. The I common-mode path refers to a signal path of common mode signals (that is, the two input signals are identical and have a same polarity) input from the I mixer, as shown in the figure, including the N-port common-mode path R11 of the I mixer and P-port common-mode path R12 of the I mixer, wherein the N-port common-mode path R11 of the I mixer refers to a common-mode signal transmission path between the N-port of the I mixer and the first tap T1, and the P-port common-mode path R12 of the I mixer refers to a common-mode signal transmission path between the P-port of the I mixer and the first tap T1. Similarly, the second tap T2 is T-shaped, and includes a second main line T21 and a second connection line T22, the second connection line T22 is configured to connect the second main line T21 and the second inductor L2, an orthographic projection of the second connection line T22 overlaps with an orthographic projection of a center line of P and N of the Q mixer. A connection point K2 of the second connection line T22 and the second inductor L2 is located on a metal line of the second inductor L2 away from the Q input terminal, and the second connection line T22 extends in a direction away from the Q input terminal, so as to make the second main line T21 away from the Q input terminal and prolong the Q common-mode path. The Q common-mode path refers to a signal path of common-mode signals input from the Q mixer, and includes an N-port common-mode path R21 of the Q mixer and a P-port common-mode path R22 of the Q mixer as shown in the figure, wherein the N-port common-mode path R21 of the Q mixer refers to a common-mode signal transmission path between the N-port of the Q mixer and the second tap T2, and the P-port common-mode path R22 of the Q mixer refers to a common-mode signal transmission path between the P-port of the Q mixer and the second tap T2.

In an exemplary embodiment, another connection mode of the tap may be as shown in FIG. 10, the difference from the example of FIG. 9 is that the first connection line T12 extends along a direction close to the I input terminal, the I common-mode paths (including R11 and R12) in this example are smaller than the I common-mode paths in the example of FIG. 9, and similarly, the second connection line extends along a direction close to the Q input terminal, the Q common-mode paths (including R21 and R22) in this example are smaller than the common-mode paths of the Q mixer in the example of FIG. 9.

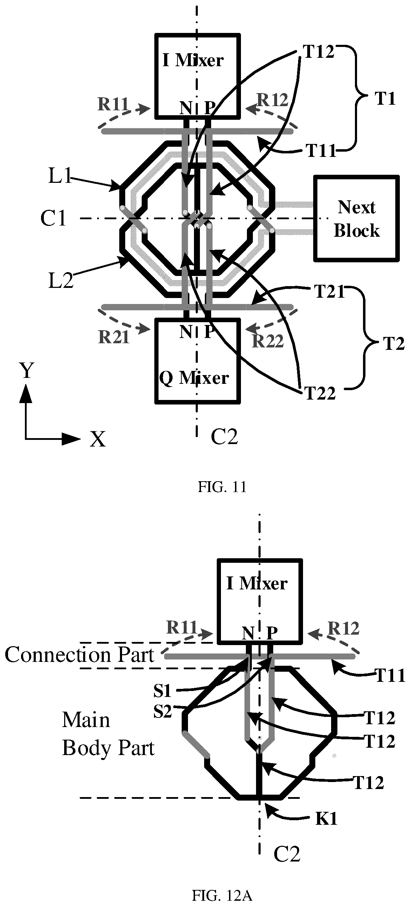

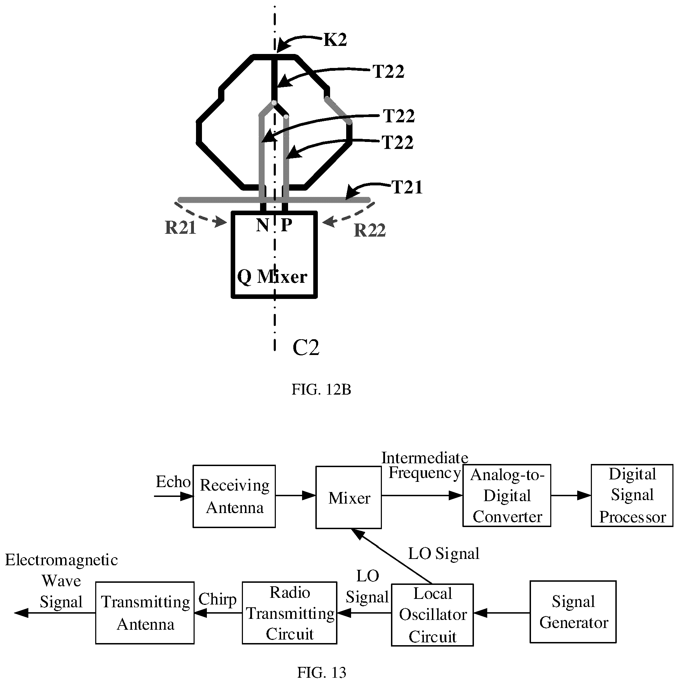

FIG. 11 is an example of still another connection mode of the tap, in which the first tap T1 and the second tap T2 are symmetrical with respect to the first symmetry axis C1. Different from the example of FIG. 9 is that, in this example the first tap T1 includes a first main line T11 and a plurality of first connection lines T12. As shown in FIG. 12A, the first main line T11 is located between the main body part of the first inductor L1 and the I input terminal, the plurality of first connection lines T12 are in a "Y" shape (the plurality of first connection lines T12 may be located in different metal layers, as the example shown in FIG. 12A, black solid line is located in one metal layer and gray solid line is located in another metal layer). The first connection line T12 and the first inductor L1 have a connection point K1, and an orthographic projection of the connection point K1 is located on a center line of P and N of the I input terminal. The first connection line T12 has two connection points (S1 and S2 in the figure) with the first main line T11, and the Y-shaped first connection lines T12 are symmetrical with respect to the second symmetry axis C2. FIG. 12B is a schematic diagram of connection between the second tap T2 and the second inductor L2. The second tap T2 also includes a second main line T21 and a plurality of second connection lines T22, and is symmetrical with the first tap T1 as a whole, which will not be repeatedly described here. The common-mode paths in this example are more certain and less susceptible to interference from other circuits.

The matching network provided by the embodiments of the present disclosure performs power combination through magnetic coupling, which has stronger isolation than electrical coupling, and is beneficial to signal isolation between the two channels (I and Q channels). Moreover, since the common-mode paths of the I channel and the Q channel are arranged separately, errors can be adjusted separately, and configuration is more flexible.

The matching network provided by the embodiments of the present disclosure may be applied to a mixer (for example, a single sideband mixer), a phase shifter, and the like. Taking an up-mixer in an up-conversion mixer in a transmission path and/or an on-chip self-test module as an example, the matching network is connected with the output terminals of the I mixer and the Q mixer to output the mixed single sideband signal. Herein the I mixer is connected with the I input terminal in the matching network, and the Q mixer is connected with the Q input terminal in the matching network. Taking an IQ phase shifter as an example, the matching network is connected with output terminals of an I phase shifter circuit and a Q phase shifter circuit to output a phase-shifted radio frequency signal, herein the I phase shifter is connected with the I input terminal in the matching network, and the Q phase shifter is connected with the Q input terminal in the matching network.

Radar chip is a detection device to convert physical quantities in the physical space into electrical signals based on a circuit built using Doppler effect formed between electromagnetic waves and velocity. FIG. 13 shows a circuit principle structure of the radar chip, including a transmitter, a receiver, an analog-to-digital converter (ADC) and a digital signal processor. The transmitter includes a signal generator, a local oscillator circuit, a radio frequency transmitting circuit, a transmitting antenna, and the like; and alternatively, an IQ phase shifter may be included in the radio frequency transmitting circuit. The receiver includes a receiving antenna, a mixer, and the like. The signal generator generates a signal with continuous frequency variation, and outputs the signal to the local oscillator circuit to form an LO signal in a transmission frequency band. The radio frequency transmitting circuit may drive and amplify the LO signal, form a chirp signal through phase control and adjustment, and convert it into an electromagnetic wave through the transmitting antenna. The electromagnetic wave is reflected by a target object to form an echo, the receiving antenna converts the echo into an echo signal, the mixer uses the LO signal to down convert the echo signal into an intermediate frequency signal, and an analog-to-digital converter converts the intermediate frequency signal into a digital signal. Herein, the digital signal corresponding to each chirp output by the analog-to-digital converter is also called a digital sequence. Using the above transceiver circuit, the radar chip may integrate multiple independent transceiver ports to form a multiple-input multiple-output (MIMO) channel matching with the antenna array, which can not only use the antenna array for a wide range of detection, but also improve the detection accuracy. The digital signal processor performs data processing on accumulated digital sequence of each receiving port, to locate a relative position of the target object with respect to the radar chip. Herein, the digital signal processor may be, such as a Digital Signal Processor (DSP), or a dedicated hardware accelerator, etc. The digital signal processor performs signal processing including at least one of the following: signal processing for improving signal-to-noise ratio (SNR), fast Fourier transform (FFT) based signal processing, constant false alarm rate (CFAR), MIMO based target estimation, or the like, to obtain the relative position.

In the example of the radar chip described above, the mixer thereof may be an IQ mixer, and an output circuit of the mixer may include the matching network provided in the aforementioned scheme.

The mixer is configured to mix signals of two or more different frequencies. Its main function is to implement frequency conversion. For example, a high frequency signal is mixed with a signal of a local oscillator to obtain an intermediate frequency signal. In more applications, the mixer may also be applied in communication systems, radars, radio receivers and other fields.

Adding the matching network in the mixer can achieve impedance matching in the circuit. The matching network can match the impedances between input and output by adjusting the values and connection modes of circuit components, so as to maximize the transmission of signal energy and reduce reflection and power consumption. In this example, the matching network of the present embodiment is added to the I and Q mixers and the next stage circuit, and the I mixer is connected to the I input terminal, and the Q mixer is connected to the Q input terminal. as shown in FIG. 4C, FIG. 5C, FIG. 6 or FIG. 7. On one hand, a physical distance between the two channels (I and Q channels) is increased, which can reduce mutual coupling of the two channels (I and Q channels) and improve an image rejection ratio. On the other hand, since the passive network is more symmetrical, the two channels (I and Q channels) are completely consistent, and bilaterally symmetrical, this arrangement will be more robust in the subsequent manufacturing process, and the resistance to process instability will be stronger, and it will be more suitable for the millimeter wave circuit which is extremely sensitive to the layout. The matching circuit applied to the mixer described above may also have a tap connected to the bias power supply, as shown in FIG. 9, FIG. 10 or FIG. 11. On one hand, I common-mode and Q common-mode can be adjusted separately. On the other hand, compared with a common mode path output by the mixer in the related art, it is more symmetrical, as shown in the figure, a transformer tap in the structure of this example is on a central line of P and N, so lengths of the common mode paths of P and N are identical, which makes the symmetry of P and N better, and thus the leakage of the local oscillator signal will be smaller.

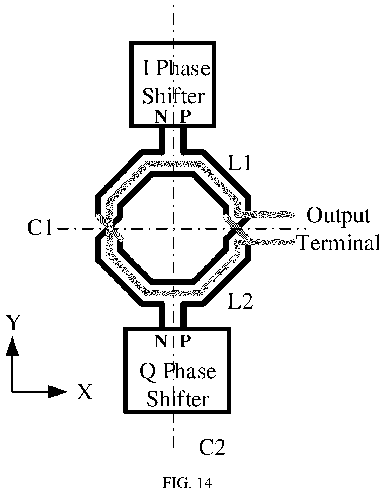

The matching network of the present embodiment can also be applied to a phase shifter of a radar chip, and the phase shifter is configured to change the phase of the signal, and it can control or adjust a phase of an input signal relative to the output signal. When the matching network is applied to the IQ phase shifter, the signal received by the radio frequency transmitting circuit is divided into two channels (I and Q channels), and enters into an I phase shifting circuit and a Q phase shifting circuit, respectively. The I phase shifting circuit is connected to the I input terminal of the matching network of the present embodiment, and the Q phase shifting circuit is connected to the Q input terminal of the matching network of the present embodiment, so as to realize impedance matching between the input and the output. FIG. 14 shows a schematic diagram of connecting the IQ phase shifter by the matching network shown in FIG. 4C as an example. The I phase shifting circuit and the Q phase shifting circuit are respectively controlled by control signals of corresponding phase shifting steps, to change phases of I and Q signals, and then a channel of a phase-shifted signal is combined through the matching network, and the combined signal is output to a next stage circuit, such as a power amplifier (PA), so as to transmit the radio frequency signal to the antenna. Since the matching network of this embodiment is adopted, it still has an advantage of suppressing leakage of I and Q signals, strong layout robustness, suppressing leakage of local oscillator signal, and the like, which will not be repeatedly described here.

Alternatively, in an exemplary embodiment of the present disclosure, the frequency modulated continuous wave signal is a millimeter wave signal, so that the electronic device can be applied to fields, such as autonomous driving, industrial automation, smart home appliances, and security inspection.

Alternatively, the radar sensor may be an AiP millimeter wave radar chip with an integrated antenna, and in some other embodiments, the radar sensor may be another type of radar chip, which is not limited herein.

In an exemplary embodiment, an embodiment of the present disclosure further provides an electronic apparatus including the aforementioned radar sensor.

Exemplarily, the electronic apparatus includes: an apparatus body, and an electronic device such as a radar sensor of the above-described embodiment provided on the apparatus body. Herein, the apparatus body is a structure which carries a radio device and is connected with the radio device with signals. The radio device achieves functions such as target detection and/or communication within a range of beam scanning by transmitting and/or receiving radio signals phase-shifted by the phaser, so as to provide detection target information and/or communication information to the apparatus body, and further assist in or even control operation of the apparatus body.

In an alternative embodiment, the above electronic apparatus including the apparatus body and the above-mentioned at least one radio device may be a component and product applied to a field, such as smart houses, transportation, smart homes, consumer electronics, monitoring, industrial automation, in-cabin detection, or health care. For example, the apparatus body may be a smart transportation device (such as an automobile, bicycle, motorcycle, ship, subway, train, etc.), a security device (such as a camera), a liquid level/flow rate detection device, a smart wearable device (such as a bracelet, glasses, etc.), a smart home device (such as a sweeping robot, a door lock, a television, an air conditioner, a smart light, etc.), various communication devices (such as a mobile phone, a tablet computer, etc.), as well as a road gate, a smart traffic light, a smart sign, a traffic camera and various industrial mechanical arms (or robots), etc. The apparatus body may be various instruments for detecting vital signs parameters and various devices equipped with the instruments, such as a device for detection in automobile cabins, a device for indoor personnel monitoring, an intelligent medical device, a consumer electronic device, etc.

## Claims

1.   A matching network of a radio frequency signal, comprising a first inductor having an I input terminal, a second inductor having a Q input terminal, and a third inductor inductively coupled to both the first inductor and the second inductor, wherein the third inductor has an output terminal; the I input terminal is configured to receive a radio frequency signal of an I channel, and the Q input terminal is configured to receive a radio frequency signal of a Q channel.

2. The matching network of claim 1, wherein the first inductor and the second inductor are arranged symmetrically.

3. The matching network of claim 1, wherein the I input terminal and the Q input terminal are symmetrically arranged away from a symmetry axis of the first inductor and the second inductor.

4. The matching network of claim 1, wherein the first inductor and the second inductor are both symmetrical structures.

5. The matching network of claim 1 or 2, wherein an orthographic projection of the first inductor partially overlaps with an orthographic projection of the second inductor.

6. The matching network of claim 1, wherein the third inductor is a symmetrical structure.

7. The matching network of claim 6, wherein a symmetry axis of the third inductor is parallel to or coincides with a symmetry axis of the first inductor and the second inductor.

8. The matching network of claim 1, wherein the I input terminal and the Q input terminal are arranged orthogonally to the output terminal, respectively.

9. The matching network of claim 1, wherein a shape of the first inductor is identical with a shape of the second inductor.

10. The matching network of claim 1 or 9, wherein an envelope shape of the first inductor and the second inductor is a regular polygon, rectangle, or circular shape.

11. The matching network of claim 1 or 6, wherein the third inductor is located between the first inductor and the second inductor, or inside an envelope of the first inductor and the second inductor, or outside an envelope of the first inductor and the second inductor.

12. The matching network of claim 1, wherein the first inductor further has a first tap for connecting a bias power supply, and the first tap is close to the Q input terminal or close to the I input terminal.

13. The matching network of claim 1 or 12, wherein the second inductor further has a second tap for connecting a bias power supply, and the second tap is close to the I input terminal or close to the Q input terminal.

14. The matching network of claim 13, wherein a first tap of the first inductor is arranged symmetrically with a second tap of the second inductor.

15. A mixer, comprising an I mixer, a Q mixer, and the matching network of the radio frequency signal as claimed in any one of claims 1 to 14, wherein the I mixer is connected to the I input terminal of the matching network, and the Q mixer is connected to the Q input terminal of the matching network.

16. A phase shifter, comprising an I phase shifter, a Q phase shifter, and the matching network of the radio frequency signal as claimed in any one of claims 1 to 14, wherein the I phase shifter is connected to the I input terminal of the matching network, and the Q phase shifter is connected to the Q input terminal of the matching network.

17. A radar sensor, comprising the mixer of claim 15 or comprising the phase shifter of claim 16.

18. An electronic apparatus, comprising the radar sensor of claim 17.

FIG. 1

FIG. 2

FIG. 3

I Input
Terminal

N P     L1

Connection Part of L1

Main Body
Part of L1

C1

Main Body
Part of L2

Connection Part of L2

L2

N P

Q Input
Terminal

Y

X

C2

FIG. 4A

Y

X

Main Body
Part

Connection
Part

FIG. 4B

I Input
Terminal
N P

L1

C1

Output
Terminal

L2

Y

X

N P
Q Input
Terminal

C2

FIG. 4C

I Input
Terminal
N P

L1

C1

Y

X

L2

N P
Q Input
Terminal

C2

FIG. 5A

FIG. 5B

FIG. 5C

I Input
Terminal
N P

L1

L2

N P
Q Input
Terminal

FIG. 6

I Input
Terminal
N P

N P
Q Input
Terminal

FIG. 7

FIG. 8

FIG. 9

FIG. 10

FIG. 11

FIG. 12A

K2

T22

T22

T22

T21

R21 → N P ← R22

Q Mixer

C2

FIG. 12B

Echo → Receiving Antenna → Mixer → Intermediate Frequency → Analog-to-Digital Converter → Digital Signal Processor

LO Signal

Electromagnetic Wave Signal ← Transmitting Antenna ← Chirp ← Radio Transmitting Circuit ← LO Signal ← Local Oscillator Circuit ← Signal Generator

FIG. 13

I Phase
Shifter
**N P**

L1

C1

Output
Terminal

L2

Y

X

**N P**
Q Phase
Shifter

C2

FIG. 14

## INTERNATIONAL SEARCH REPORT

| International application No. |
| --- |
| **PCT/CN2023/142045** |

**A. CLASSIFICATION OF SUBJECT MATTER**

H03H 7/38(2006.01)i

According to International Patent Classification (IPC) or to both national classification and IPC

**B. FIELDS SEARCHED**

Minimum documentation searched (classification system followed by classification symbols)

IPC:H03H

Documentation searched other than minimum documentation to the extent that such documents are included in the fields searched

Electronic data base consulted during the international search (name of data base and, where practicable, search terms used)

CNABS, CNTXT, VEN, ENTXT, DWPI, IEEE: 射频, 匹配网络, 匹配电路, 电感, I路, Q路, 正交, 移相器, 混频器, radio, matching networks, matching circuit, inductance, orthogonal, phaser, mixer

**C. DOCUMENTS CONSIDERED TO BE RELEVANT**

| Category* | Citation of document, with indication, where appropriate, of the relevant passages | Relevant to claim No. |
| --- | --- | --- |
| X | CN 217445328 U (NO.54 RESEARCH INSTITUTE OF CETC) 16 September 2022 (2022-09-16)<br>description, paragraphs 31 and 35, and figure 1 | 1-14 |
| Y | CN 217445328 U (NO.54 RESEARCH INSTITUTE OF CETC) 16 September 2022 (2022-09-16)<br>description, paragraphs 31 and 35, and figure 1 | 15-18 |
| Y | CN 113965167 A (TIANJIN UNIVERSITY) 21 January 2022 (2022-01-21)<br>description, paragraph 27, and figure 1 | 15, 17-18 |
| Y | CN 113328728 A (NANJING UNIVERSITY OF SCIENCE AND TECHNOLOGY) 31 August 2021 (2021-08-31)<br>description, paragraph 3 | 16-18 |
| A | CN 116094891 A (FIRST RESEARCH INSTITUTE OF THE MINISTRY OF PUBLIC SECURITY) 09 May 2023 (2023-05-09)<br>entire document | 1-18 |
| A | CN 116582107 A (ZHEJIANG UNIVERSITY) 11 August 2023 (2023-08-11)<br>entire document | 1-18 |

| ✓ Further documents are listed in the continuation of Box C. | ✓ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **29 April 2024** | **08 May 2024** |

| Name and mailing address of the ISA/CN | Authorized officer |
| --- | --- |
| **China National Intellectual Property Administration (ISA/ CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

International application No.

**PCT/CN2023/142045**

### C.    DOCUMENTS CONSIDERED TO BE RELEVANT

| Category* | Citation of document, with indication, where appropriate, of the relevant passages | Relevant to claim No. |
|---|---|---|
| A | US 2019334489 A1 (NXP B. V.) 31 October 2019 (2019-10-31)<br>entire document | 1-18 |

**INTERNATIONAL SEARCH REPORT**
**Information on patent family members**

| Patent document cited in search report | | | Publication date (day/month/year) | Patent family member(s) | | | Publication date (day/month/year) |
|---|---|---|---|---|---|---|---|
| CN | 217445328 | U | 16 September 2022 | CN | 114640323 | A | 17 June 2022 |
| CN | 113965167 | A | 21 January 2022 | None | | | |
| CN | 113328728 | A | 31 August 2021 | None | | | |
| CN | 116094891 | A | 09 May 2023 | CN | 219843620 | U | 17 October 2023 |
| CN | 116582107 | A | 11 August 2023 | None | | | |
| US | 2019334489 | A1 | 31 October 2019 | EP | 3562036 | A1 | 30 October 2019 |
| | | | | CN | 110176909 | A | 27 August 2019 |

Form PCT/ISA/210 (patent family annex) (July 2022)

**REFERENCES CITED IN THE DESCRIPTION**

**Patent documents cited in the description**

- CN 202311148800